Europäisches Patentamt

European Patent Office

Office européen des brevets

(19)

(11) Veröffentlichungsnummer : **0 361 196 B1**

(12) **EUROPÄISCHE PATENTSCHRIFT**

(45) Veröffentlichungstag der Patentschrift :
**02.12.92 Patentblatt 92/49**

(51) Int. Cl.$^5$ : **H05K 7/20,** G06F 1/00

(21) Anmeldenummer : **89116805.6**

(22) Anmeldetag : **11.09.89**

(54) **Kühlmediumsverteilungssystem.**

(30) Priorität : **29.09.88 DE 3833100**

(43) Veröffentlichungstag der Anmeldung :
**04.04.90 Patentblatt 90/14**

(45) Bekanntmachung des Hinweises auf die
Patenterteilung :
**02.12.92 Patentblatt 92/49**

(84) Benannte Vertragsstaaten :
**AT BE CH DE FR GB IT LI NL**

(56) Entgegenhaltungen :
**DE-A- 3 244 654**
**FR-A- 2 580 060**
**E/MJ ENGINEERING AND MINING JOURNAL.**
**vol. 150, November 1949, NEW YORK US Seite**
**125 ANDREWS-KNAPP CONSTR.: "New tu-**
**bing hasadvantages. "**

(73) Patentinhaber : **Siemens Nixdorf**
**Informationssysteme AG**
**Otto-Hahn-Ring 6**
**W-8000 München 83 (DE)**

(72) Erfinder : **Schmalzl, Dieter**
**Reichenauerstrasse 39**
**W-8000 München 60 (DE)**
Erfinder : **Sotiriu, Cornelius**
**U. Jakobermauer 13**
**W-8900 Augsburg (DE)**
Erfinder : **Mikes, Georg**
**Am Flutgraben 11**
**W-8904 Friedberg (DE)**

(74) Vertreter : **Fuchs, Franz-Josef, Dr.-Ing. et al**
**Postfach 22 13 17**
**W-8000 München 22 (DE)**

# Beschreibung

Die Erfindung betrifft ein Kühlmediumverteilungssystem für einen geschlossenen Kreislauf zur Kühlung elektronischer Baugruppen, die in einem Gehäuse angeordnet sind; siehe z.B. FR-A-2580060.

Für flüssigkeitsgekühlte Zentraleinheiten von Datenverarbeitungssystemen ist in einem Gehäuse zwischen elektronischen Baugruppen und Stromversorgungen ein Kühlmediumverteilungssystem für einen geschlossenen Kreislauf zur Kühlung elektronicher Baugruppen mit hoher Verlustleistung erforderlich.

An dieses Verteilungssystem werden extrem hohe Anforderungen in Bezug auf Dichtheit und Korrosionsbeständigkeit gestellt um Schäden und Ausfall der teuren Anlage zu vermeiden.

Bekannte Produkte sind durch die Verwendung von sehr unterschiedlichen Materialien wie z.B. Stahl, Edelstahl, Kunststoff, Gummi und Cu-Werkstoffe und ihre ungünstige Kombination anfällig gegen Korrosion, Verschlammung, elektrostatische Aufladung, Undichtigkeit und Versprödung. Zur Vermeidung von Korrosion wird das Kühlmedium häufig mit sehr toxischen und wartungsintensiven Inhibitoren versehen.

Lösbare Verbindungen werden zum Teil sehr aufwendig über Schneidringverschraubungen oder primitiv über einfach abgesicherte Verschraubungen und sogar Schlauchschellen hergestellt.

Unlösbare Verbindungen werden durch Schweißen, (Gefahr wenn nicht bis zur Wurzel durchgeschweißt ist) weich- und harlöten (Korrosionsgefahr wenn Werkstoffauswahl ungünstig ist, z.B. Messerschnittkorrosion bei Edelstahl) realisiert.

Aufgabe der vorliegenden Erfindung ist es, ein korrosionsbeständiges Kühlmediumverteilungssystem zu schaffen.

Zur Lösung dieser Aufgabe wird das Kühlmediumverteilungssystem derart ausgebildet, daß

a) alle kühlmediumführenden Teile innerhalb des Gehäuses aus Kupfer oder Kupferbasiswerkstofen mit mindestens 88% Kupfer ausgeführt sind, daß

b) alle unlösbaren Verbindungen zwischen Teilen aus Kupfer und/oder Kupferbasiswerkstoffen mit Silberlot hartgelötet sind, daß

c) alle lösbaren Verschraubungen neben einer metallischen Konusringdichtung zusätzlich mit einer O-Ringdichtung versehen sind, daß

d) als Kühlmedium destilliertes Wasser, das mit Natronlauge auf einem PH-Wert von ca. 8,5 versetzt ist, verwendet wird, und daß

e) eine Entlüftungseinrichtung aus Messing durch eine Verschraubung aus Zinnbronze mit einem Konus- und einem O-Ring gekapselt ist.

f) daß Verbindungen zu beweglichen Teilen dieses Kühlsystems aus flexiblen metallischen Wellschläuchen ausgeführt sind.

Durch diese Maßnahmen wird ein Kühlsystem mit extrem hoher zeitbeständiger Dichtigkeit geschaffen. Durch die Verwendung von Metall wird eine mögliche elektrostatische Aufladung verhindert eine Verschlammung durch Materialauflösung ausgeschlossen und ein eindiffunieren von Sauerstoff vermieden (Verbindung von Korrosion).

Anhand des Ausführungsbeispiels wird die Erfindung näher erläutert.

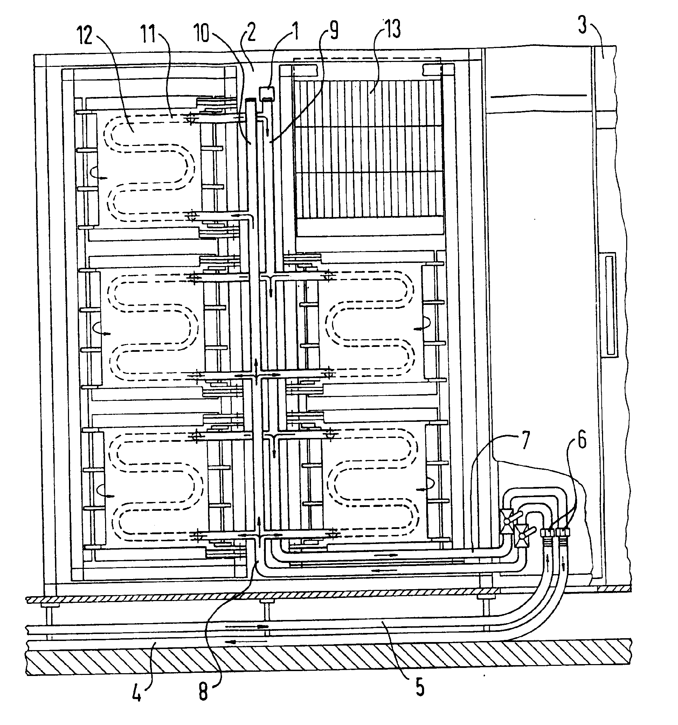

Die Figur zeigt von links nach rechts einen Attached-Prozessor 2 mit Speicher und ein Kanalwerk 3. Alle Einrichtungen befinden sich in Schrankgehäusen, wobei der linke Teil ohne Türen dargestellt ist, so daß der Einblick in das Innere eines solchen Schranks freigegeben ist. Unterhalb des Schrankes sind die Kühlwasserableitung 4 und die Kühlwasserzuleitung 5 zu sehen, die jeweils das Kühlmittel über einen externen Anschluß 6 erhalten. Die Kühlmedienleitungen 7 und 8 führen durch das Innere des Prozessorschrankes, wobei senkrecht in der Mitte die Mediumzuführungs- und -abführungsleitung 9 und 10 zu sehen sind. Diese Leitungen sind lösbar mit mäanderförmig ausgebildeten Leitungen 11 verbunden, die wiederum in einer Kühlplatte 12 angeordnet sind, wobei auf der Oberseite dieser Kühlplatte integrierte Schaltungseinheiten, die zu kühlen sind, angebracht werden, die jedoch in der vorliegenden Figur nicht dargestellt sind. Rechts von der Mitte des mittleren Schrankes befindet sich ein zusätzlicher Lüfter 13, der neben dem durch die Leitungen fließenden Kühlmedium für eine zusätzliche Luftkühlung sorgt.

## Patentansprüche

1. Kühlmediumverteilungssystem für einen geschlossenen Kreislauf zur Kühlung elektronischer Baugruppen, die in einem Gehäuse angeordnet sind, **gekennzeichnet durch** die Kombination folgender Merkmale:

a) daß alle Kühlmedium führenden Teile innerhalb des Gehäuses aus Kupfer oder Kupferbasiswerkstoffen mit mindestens 88% Kupfer ausgeführt sind,

b) daß alle unlösbaren Verbindungen zwischen Teilen aus Kupfer und/oder Kupferbasiswerkstoffen mit Silberlot hartgelötet sind,

c) daß alle lösbaren Verschraubungen neben einer metallischen Konusringdichtung zusätzlich mit einer O-Ringdichtung versehen sind,

d) daß als Kühlmedium destilliertes Wasser, das mit Natronlauge auf einem PH-Wert von ca. 8,5 versetzt ist, verwendet wird,

e) daß eine Entlüftungseinrichtung aus Messing durch eine Verschraubung aus Zinnbronze mit einem Konus- und einem O-Ring gekapselt ist.

f) daß Verbindungen zu beweglichen Teilen dieses Kühlsystems aus flexiblen metalli-

schen Wellschläuchen ausgeführt sind.

tème de refroidissement sont constituées à l'aide de tuyaux métalliques souples ondulés.

**Claims**

1. Cooling medium distribution system for a closed circuit for cooling electronic assemblies which are arranged in a housing, characterised by the combination of the following features:

a) that all the parts within the housing which carry the cooling medium are made out of copper or copper-based materials having at least 88% of copper,

b) that all non-detachable connections between parts composed of copper and/or copper-based materials are hard-soldered with silver solder,

c) that all detachable screw connections are additionally provided with an O-ring seal as well as a metallic conical ring seal,

d) that distilled water, which is adjusted to a pH value of approximately 8.5 using sodium-hydroxide solution, is used as the cooling medium,

e) that a brass venting device is encapsulated by means of a screw connection composed of tin bronze, with a conical ring and an O-ring,

f) that connections to moving parts of this cooling system are designed from flexible metallic corrugated hoses.

**Revendications**

1. Système de répartition du fluide de refroidissement pour un circuit fermé destiné au refroidissement de modules électroniques disposés dans un boîtier, remarquable par la combinaison des caractéristiques suivantes :

a) toutes les parties conduisant le fluide de refroidissement à l'intérieur du boîtier sont en cuivre ou en matériaux à base de cuivre ayant au moins 88 % de cuivre,

b) toutes les liaisons non détachables entre les parties en cuivre et/ou en matériaux à base de cuivre sont brasées par de la soudure à l'argent,

c) tous les vissages qui peuvent être dévissés sont munis, en plus d'un dispositif d'étanchéité annulaire conique métallique, d'un joint torique,

d) il est utilisé, comme fluide de refroidissement, de l'eau distillée mélangée à de la lessive caustique jusqu'à un pH de 8,5 environ,

e) un dispositif de ventilation en laiton est encapsulé à l'aide d'un vissage en bronze d'étain à joint conique et à joint torique,

f) les liaisons entre parties mobiles de ce sys-